# FASCICULE DE BREVET EUROPEEN

(11) **EP 2 788 782 B1**
(45) Date de publication et mention de la délivrance du brevet: **09.12.2015**
(21) Numéro de dépôt: 12819073.3
(22) Date de dépôt: 10.12.2012
(51) Int. Cl.: G01S 3/784, H04N 5/33, H01L 27/144

(54) **DISPOSITIF DE DÉTECTION DE RAYONNEMENT ÉLECTROMAGNÉTIQUE IMPULSIONNEL**
VORRICHTUNG ZUR ERKENNUNG GEPULSTER ELEKTROMAGNETISCHER STRAHLUNG
DEVICE FOR DETECTING PULSED ELECTROMAGNETIC RADIATION

(30) Priorité: 08.12.2011 FR 1103765
(43) Date de publication de la demande: 15.10.2014
(73) Titulaire: Société Française de Détecteurs Infrarouges - SOFRADIR, 91120 Palaiseau (FR)
(72) Inventeur: SANSON, Eric, F-38000 Grenoble (FR)
(74) Mandataire: Talbot, Alexandre
(86) Numéro de dépôt international: PCT/FR2012/000511
(87) Numéro de publication internationale: WO 2013/083889

(56) Documents cités:
- EP-A2- 0 083 411
- EP-A2- 0 691 742
- US-A1- 2010 213 352
- BEDABRATA PAIN ET AL: "A Review of Infrared Readout Electronics for Space Science Sensors", SPIE PROCEEDINGS, THE INTERNATIONAL SOCIETY FOR OPTICAL ENGINEERING - SPIE, BELLINGHAM, WASHINGTON, USA, vol. 2020, 15 juin 1993 (1993-06-15), pages 1-47, XP002457338, ISSN: 0277-786X

## Description

L'invention est relative à un dispositif de détection de rayonnement électromagnétique.

### État de la technique

Les dispositifs de détection d'un rayonnement électromagnétique peuvent être utilisés pour l'observation d'une scène variant lentement ou pour la détection d'impulsions, c'est-à-dire pour la détection d'un signal très puissant durant une courte période.

La gestion d'un signal lumineux très intense durant une très courte période impose de nombreuses contraintes techniques sur le circuit de détection. De manière classique, la gestion d'un flux important de courant durant un temps très court dans le circuit de détection impose d'avoir une bande passante importante pour que l'énergie de l'impulsion ne soit pas diluée temporellement ce qui la rendrait difficile à détecter. Une bande passante importante représentative d'une vitesse d'exécution élevée est généralement obtenue avec un dispositif ayant une consommation électrique importante.

Il existe également une contrainte sur la sensibilité du dispositif au niveau du rayonnement observé afin d'éviter que l'impulsion ne soit pas détectée. Bien que le signal soit très puissant, il n'existe que pendant une durée très courte, il faut donc s'assurer que le dispositif soit en mesure de détecter l'impulsion. Différents modes de réalisation ont été décrits dans l'art antérieur afin de détecter un signal impulsionnel. Dans le document FR 2753796 illustré à la figure 1, une photodiode 1 reçoit le rayonnement électromagnétique à analyser. La cathode de la photodiode 1 est connectée à une première résistance 2 et aux deux bornes d'entrée d'un amplificateur 3. Une seconde résistance 4 est connectée entre la borne de sortie et une des bornes d'entrée de l'amplificateur 3 afin de former un circuit électrique dérivateur 5. Une troisième résistance est connectée entre la cathode de la photodiode et une des bornes d'entrée de l'amplificateur 3.

Cette architecture est difficilement intégrable, notamment dans des dispositifs autonomes car le courant de polarisation d'un tel dispositif doit être important pour obtenir une vitesse d'exécution élevée.

Le document US2010/0213352A1 décrit un circuit dit à injection directe réalisé par un transistor MOSFET pour garder une tension constante sur le photodétecteur.

Dans le document US 2003/0205663, illustré à la figure 2, la photodiode 1 est polarisée entre son substrat et une tension d'alimentation Vd au moyen de deux transistors à effet de champ T1 et T2 qui forment un circuit de polarisation 6. La cathode de la photodiode 1 connectée au circuit de polarisation 6 est également connectée à l'électrode de grille d'un transistor d'amplification T3. Le signal lumineux reçu par la photodiode 1 est appliqué sur l'électrode de grille du transistor de polarisation T3 qui amplifie ce signal pour l'envoyer depuis l'électrode de drain du transistor d'amplification T3 vers la borne de sortie 7. La borne de sortie 7 est connectée au circuit de polarisation 6.

Comme dans le mode de réalisation précédent, le transistor de polarisation T3 doit être soumis à une polarisation importante afin de pouvoir gérer la quantité d'énergie délivrée par la photodiode 1 avec une vitesse d'exécution élevée ce qui pose un problème de consommation électrique. Le document est de plus évasif sur le circuit suiveur. Ce circuit suiveur doit être lent, mais aucune information précise n'est fournie pour expliquer comment obtenir la lenteur recherchée. Comme le courant de polarisation est défini par la photodiode 1, il peut y avoir un problème de stabilité de la boucle de contre-réaction. Ainsi, un tel enseignement ne permet pas une réalisation viable d'un détecteur d'impulsions.

### Objet de l'invention

On constate qu'il existe un besoin de prévoir un dispositif de détection qui est capable de détecter des signaux impulsionnels avec une consommation électrique réduite.

On tend à combler ce besoin au moyen d'un dispositif qui comporte :
- un photodétecteur transformant le rayonnement électromagnétique reçu en un courant électrique,
- un circuit de polarisation connecté aux bornes du photodétecteur,
- un circuit d'amplification distinct du circuit de polarisation et comportant un transistor d'amplification formé par un transistor à effet de champ ou un transistor bipolaire ayant une première électrode de source ou d'émetteur formant une borne d'entrée du circuit d'amplification couplée à une borne du photodétecteur et une deuxième électrode de drain ou de collecteur couplée à une borne de sortie du circuit de détection, le circuit d'amplification étant configuré de manière ce que le transistor d'amplification soit parcouru par le courant appliqué sur la première électrode de source ou d'émetteur et à fournir ce courant sur la borne de sortie avec une impédance plus élevée que sur la première électrode de source ou d'émetteur,
- une source de tension connectée à l'électrode de commande du transistor d'amplification,
- une charge électrique passive connectée à la deuxième électrode de drain ou de collecteur du transistor d'amplification.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

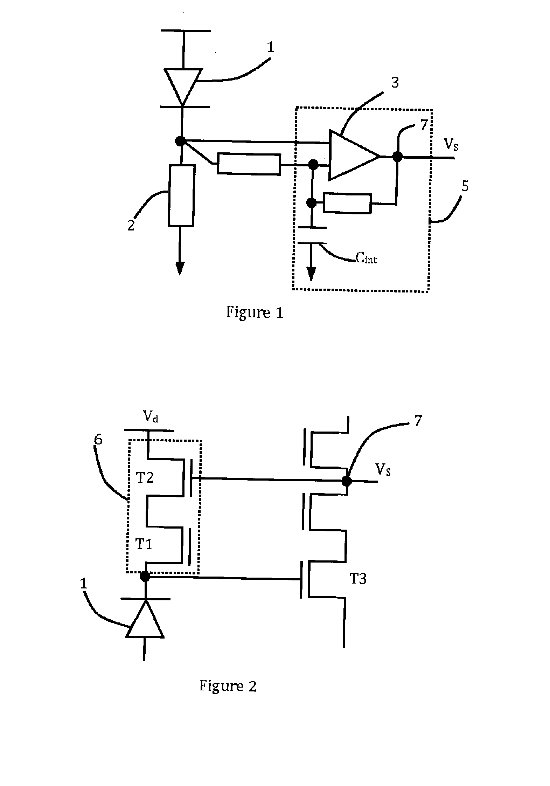

- la figure 1 représente, de manière schématique, un premier circuit de détection selon l'art antérieur,
- la figure 2 représente, de manière schématique, un deuxième circuit de détection selon l'art antérieur,
- la figure 3 représente, de manière schématique, un circuit de détection selon l'invention,
- la figure 4 représente, de manière schématique, un circuit de détection particulier selon l'invention,
- la figure 5 représente, de manière schématique, un autre circuit de détection particulier selon l'invention,
- les figures 6 et 7 représentent, de manière schématique, deux modes de mise en oeuvre encore plus particuliers d'un circuit de détection selon la figure 5.

### Description de modes de réalisation préférentiels de l'invention

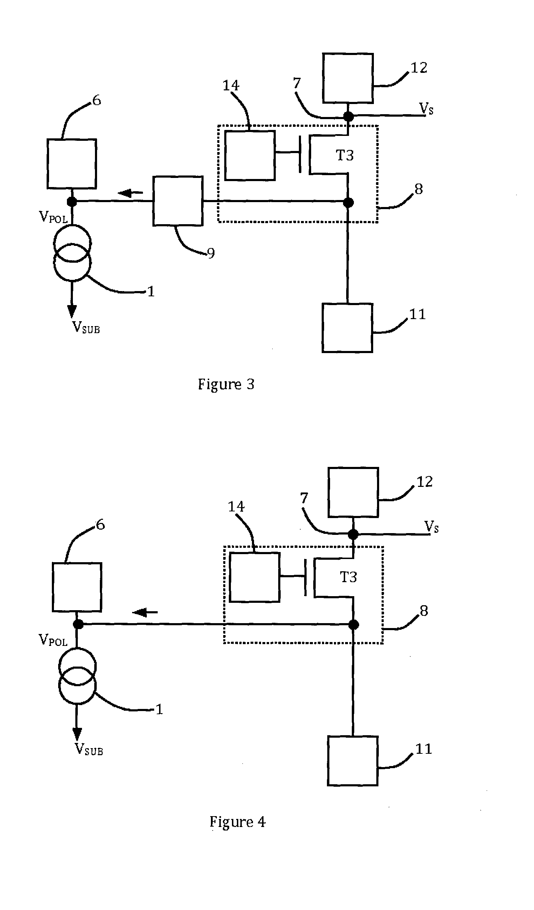

Comme cela est illustré à la figure 3, le dispositif de détection comporte un photodétecteur 1 schématisé sous la forme d'une source de courant, capable de convertir le signal lumineux reçu en un signal électrique. Le photodétecteur 1 est configuré pour détecter un rayonnement électromagnétique dans une gamme précise de longueur d'ondes.

Le photodétecteur 1 peut être formé par tout dispositif adapté, par exemple par une photodiode ou par un dispositif à puits quantique ou à multi-puits quantiques. Le photodétecteur est avantageusement configuré pour détecter un rayonnement infrarouge, de préférence, une gamme particulière du rayonnement infrarouge, par exemple les gammes, LWIR, MWIR ou SWIR.

Le dispositif de détection comporte également un circuit de polarisation 6 du photodétecteur 1. Le circuit de polarisation 6 est configuré de manière à ce que le photodétecteur 1 agisse comme une source de courant dont l'intensité du courant est fonction du rayonnement électromagnétique reçu.

Le circuit de polarisation 6 impose une première différence de potentiel aux bornes du photodétecteur 1. Le circuit de polarisation est avantageusement connecté aux bornes du photodétecteur 1. Un premier potentiel, par exemple un potentiel de substrat V_{SUB}, est appliqué sur une première borne du photodétecteur 1. Un deuxième potentiel, par exemple un potentiel de polarisation V_{POL} est appliqué sur la deuxième borne du photodétecteur 1.

Le circuit de polarisation 6 peut être actif ou passif. Par circuit passif, on entend un circuit ne permettant pas une amplification. Un tel circuit est constitué par des éléments passifs, par exemples des diodes, des résistances, des condensateurs. Par circuit actif, on entend un circuit apte à réaliser l'amplification, aux bornes du photodétecteur 1, de la polarisation délivrée par une source de tension. Un circuit actif permet une meilleure régulation du point de polarisation appliqué au photodétecteur. Un tel circuit comprend au moins un transistor permettant de moduler la tension appliquée et il nécessite une consommation électrique plus importante qu'avec un circuit passif.

Le circuit de polarisation 6 est configuré pour polariser le photodétecteur 1 dans son mode de fonctionnement recherché. Comme le circuit de polarisation 6 est couplé au photodétecteur 1, il est configuré pour ne pas complètement absorber le signal électrique impulsionnel émis. Le circuit de polarisation 6 et un circuit d'amplification 8 sont connectés ou couplés au photodétecteur 1 de manière à définir deux chemins distincts de circulation du courant émis par le photodétecteur 1.

Le circuit de polarisation 6 et le circuit d'amplification 8 sont configurés de manière à ce que la partie impulsionnelle du signal émis par le photodétecteur 1 atteigne majoritairement le circuit d'amplification 8 et donc ne traverse pas trop le circuit de polarisation 6 et que la partie statique du signal émis atteigne majoritairement le circuit de polarisation 6 et donc ne traverse pas trop le circuit d'amplification 8.

Dans cette configuration, le signal électrique impulsionnel émis par le photodétecteur 1 est représentatif de l'impulsion lumineuse reçue et ce signal électrique impulsionnel passe en priorité dans le circuit d'amplification 8.

Dans le but d'assurer sa fonction de polarisation, la borne du circuit de polarisation 6 connectée au photodétecteur 1 présente une première valeur d'impédance qui est faible dans le domaine des basses fréquences et avantageusement dans le domaine de courant envisagé pour le photodétecteur 1. Cette borne présente en plus, de préférence, une valeur d'impédance plus élevée dans le domaine des hautes fréquences afin d'empêcher la perte des signaux impulsionnels en courant dans le circuit de polarisation et afin de favoriser le passage du courant à l'intérieur du circuit d'amplification 8.

De manière avantageuse, la borne d'entrée du circuit d'amplification 8 présente une basse impédance dans le domaine des hautes fréquences et avantageusement des forts courants. Elle possède également une impédance plus élevée dans le domaine des basses fréquences et avantageusement des faibles courants.

Dans le domaine des basses fréquences, l'impédance d'entrée du circuit d'amplification 8 est supérieure à l'impédance d'entrée du circuit de polarisation 6. Dans le domaine des fréquences élevées, l'impédance d'entrée du circuit d'amplification 8 est inférieure à l'impédance d'entrée du circuit de polarisation 6.

Le passage du domaine des basses fréquences au domaine des fréquences élevées se fait aux environs de 1 MHz, typiquement pour une valeur comprise dans la gamme 0,5-10MHz selon le type d'application visé.

Une des bornes du photodétecteur 1, ici la deuxième borne, est également couplée au circuit d'amplification 8. Le circuit d'amplification 8 reçoit, sur une borne d'entrée, le signal électrique ou une partie de l'intensité du signal électrique émis par le photodétecteur 1. Le circuit d'amplification 8 produit sur sa borne de sortie un signal représentatif de l'information reçue sur la borne d'entrée, c'est-à-dire un signal représentatif de l'information émise par le photodétecteur 1. Le signal en sortie du circuit 8 est amplifié par rapport au signal présent en entrée du circuit 8. La borne de sortie du circuit d'amplification 8 forme la borne de sortie 7 du dispositif de détection.

Dans un mode de réalisation particulier pouvant être combiné avec les précédents, la borne de sortie 7 du circuit d'amplification 8 présente une impédance plus élevée que sa borne d'entrée de manière à convertir le signal en courant provenant de la borne d'entrée en un signal en tension sur la borne de sortie 7. La borne d'entrée du circuit 8 est représentée par la première électrode du transistor T3. Dans cette configuration, il est avantageux d'avoir une conservation du courant transitant entre la borne d'entrée et la borne de sortie du circuit 8 pour obtenir simplement le gain recherché.

Le circuit d'amplification 8 est polarisé par une deuxième différence de potentiel imposée par des première et seconde bornes d'un circuit de polarisation additionnel.

L'entrée du circuit d'amplification 8 est réalisée par un transistor d'amplification T3. Le transistor d'amplification T3 peut être un transistor à effet de champ dont l'électrode de source, ou première électrode, reçoit le signal provenant du photodétecteur 1. L'électrode de drain, ou deuxième électrode, est couplée à la borne de sortie 7 du dispositif de détection. Le courant qui traverse le transistor d'amplification T3 est fonction et représentatif du signal émis par le photodétecteur 1. Le transistor d'amplification T3 peut également être réalisé en technologie bipolaire. Dans ce cas, l'émetteur (première électrode) reçoit le signal du photodétecteur 1 et le collecteur (deuxième électrode) est couplé à la borne de sortie 7. De manière générale, le circuit d'amplification également appelé amplificateur 8 comporte un transistor d'amplification T3 ayant une électrode à basse impédance couplée au photodétecteur 1. Le transistor d'amplification T3 est traversé par le signal ou une partie du signal émis par le photodétecteur 1. De manière avantageuse, le transistor d'amplification T3 est connecté au photodétecteur afin de conserver un circuit compact et une vitesse d'exécution élevée. La deuxième électrode du transistor est couplée à la borne de sortie 7. Le circuit d'amplification 8 est configuré de manière à ce que la première électrode du transistor T3 reçoive, de préférence plus de 50% du courant émis par le photodétecteur. Le circuit d'amplification 8 est également configuré de manière à ce que le courant reçu par le transistor T3 arrive sur la première électrode et soit transféré vers la deuxième électrode et la borne de sortie 7. Comme la première électrode à une impédance plus faible que la deuxième électrode il y a un gain en tension.

Dans ce mode de réalisation, le signal émis par le photodétecteur 1 ou un signal représentatif est appliqué sur une borne à basse impédance ce qui améliore le temps de réponse du dispositif de détection. L'électrode de source ou d'émetteur d'un transistor présente une impédance beaucoup plus faible que l'impédance de l'électrode de grille ou de base de ce même transistor.

Par ailleurs, le signal provenant du photodétecteur 1 génère un courant additionnel à travers le transistor d'amplification T3 ce qui permet, dans certains modes de réalisation, d'augmenter le courant de polarisation durant la période utile, c'est-à-dire durant la durée de d'impulsion lumineuse. En dehors de la durée de l'impulsion, le courant de polarisation est réduit ce qui permet de limiter la consommation électrique du dispositif.

Dans cette configuration, le dispositif de détection peut présenter un faible courant de polarisation au repos. Lorsque le photodétecteur reçoit une impulsion de lumière, l'impulsion de courant émise par le photodétecteur 1 entraîne le passage d'un courant plus important dans le transistor d'amplification T3 ce qui vient modifier les conditions de polarisation de l'amplificateur 8. Le courant émis en réponse à l'impulsion lumineuse agit comme un courant de polarisation additionnel ce qui permet, dans le cas d'une configuration additionnelle avantageuse, d'augmenter la bande passante de l'amplificateur 8 au moment précis du passage de l'impulsion. Il est alors possible de réduire le courant de polarisation de l'amplificateur 8 pendant l'attente de l'impulsion et ainsi réduire la consommation globale du circuit. Bien que le circuit ressemble à un dispositif monté en injection directe, le fonctionnement est différent. Alors que dans un circuit à injection directe, le but est d'intégrer des charges électriques, ce circuit a pour fonction d'amplifier le signal émis par le photodétecteur 1. Afin d'intégrer ces charges, la valeur de capacité électrique du condensateur est adaptée au besoin et elle est placé en sortie du circuit. En revanche, dans ce mode de réalisation, le condensateur présente une capacité électrique plus faible de manière à améliorer le temps de réponse. De manière préférentielle, la valeur du condensateur est réduite autant que possible pour avoir un temps de réponse très faible.

Dans un mode de réalisation avantageux car compact, la borne de sortie 7 est formée par l'électrode de drain ou le collecteur du transistor d'amplification T3.

De manière avantageuse, le transistor d'amplification T3 est configuré avec le circuit de polarisation 6 et le photodétecteur 1 de manière à ce que le courant traversant le transistor d'amplification T3 soit orienté dans le même sens que le courant participant à la polarisation du photodétecteur 1. Dans ces conditions, la valeur de l'impédance de l'électrode de source du transistor T3 diminue ce qui augmente la réactivité et donc la bande passante du transistor d'amplification.

Grâce à cette réduction d'impédance, l'injection du courant dans le transistor d'amplification T3 est améliorée.

La deuxième borne du photodétecteur 1 est couplée au circuit d'amplification 8 par l'intermédiaire d'un circuit de couplage 9 qui permet de faire passer le signal émis par le photodétecteur 1 ou une partie de ce signal sur la borne d'entrée du circuit d'amplification 8.

Dans un mode de réalisation particulier illustré à la figure 4 et qui peut être combiné avec les modes de réalisation précédents, le circuit de couplage 9 est formé par une ligne conductrice qui relie directement la deuxième borne du photodétecteur 1 à la borne d'entrée du circuit d'amplification 8. Dans cette configuration, le circuit d'amplification 8 reçoit directement le signal émis par le photodétecteur 1. Seule une petite partie du signal est perdue dans le circuit de polarisation 6 en fonction des performances de ce dernier.

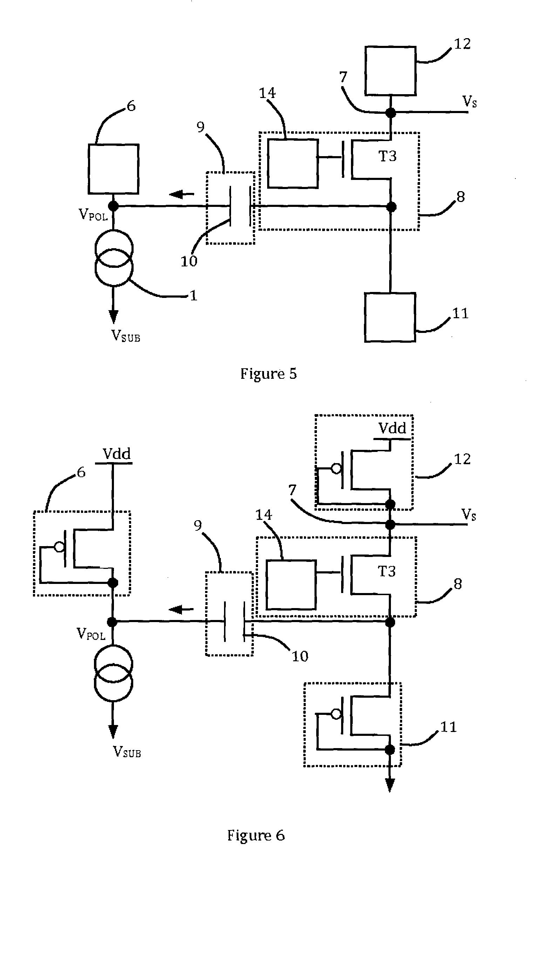

Dans une autre variante de réalisation illustrée à la figure 5 et qui peut être combinée avec les modes de réalisation précédents (sauf celui de la figure 4), le circuit de couplage 9 comporte un condensateur de couplage 10 qui est connecté entre le photodétecteur 1 et le circuit d'amplification 8. Le condensateur de couplage 10 bloque le passage d'une partie du signal émis par le photodétecteur 1. Le condensateur de couplage 10 est agencé de manière à bloquer la composante continue et les variations lentes du signal lumineux émis par le photodétecteur 1 pour ne laisser passer que la composante variable rapide, c'est-à-dire l'impulsion de courant.

De manière avantageuse, le circuit de couplage 9 est formé par le condensateur de couplage 10 qui présente une première borne connectée au photodétecteur 1 et au circuit de polarisation 6 et une deuxième borne connectée à l'électrode de source (ou émetteur) du transistor d'amplification T3.

Dans un mode de réalisation préférentiel pouvant être combiné avec les modes de réalisation précédents, le circuit de polarisation additionnel comporte une première charge électrique passive 11 disposée entre le transistor d'amplification T3 et la première borne du circuit de polarisation additionnel. La première charge électrique passive 11 permet d'écouler le courant de repos du transistor T3. La première charge électrique passive permet également de faire barrage au courant impulsionnel pour le diriger vers le transistor d'amplification T3.

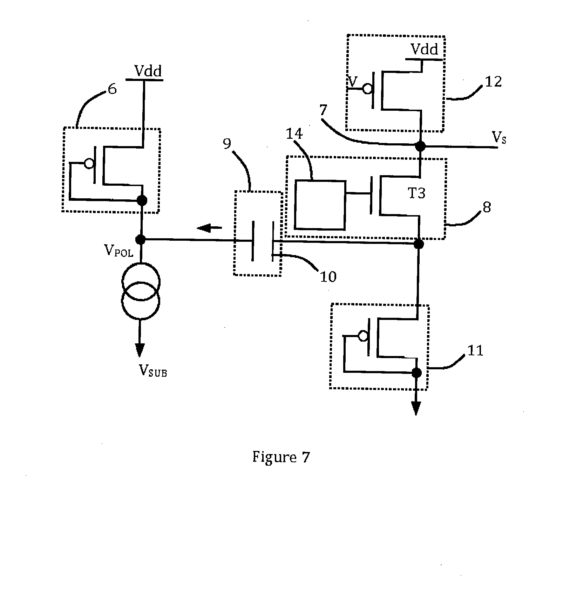

Dans un mode de réalisation préférentiel, la première charge électrique passive 11 est configurée pour ne pas dériver ou pour limiter la dérivation du courant représentatif de l'impulsion lumineuse. Cette architecture particulière permet au dispositif de se repositionner plus rapidement dans une configuration d'attente de la prochaine impulsion et donc de réduire la consommation du dispositif final. Dans un mode de réalisation encore plus particulier illustré aux figures 6 et 7, la première charge électrique passive 11 a la caractéristique électrique d'une diode. La première charge passive 11 peut être formée, par exemple, par une diode ou un transistor agencé pour fonctionner comme une diode, par exemple en connectant ensemble les électrodes de grille et de drain.

La première charge électrique passive est couplée à l'électrode de source (ou émetteur) du transistor T3.

Dans une autre variante de réalisation qui peut être combinée avec les modes de réalisation précédents, le circuit comporte une deuxième charge électrique passive 12 couplée à l'électrode de drain (ou collecteur) du transistor d'amplification T3. La deuxième charge électrique passive 12 est disposée entre le transistor d'amplification T3 et la deuxième borne du circuit de polarisation additionnel. La deuxième charge électrique passive 12 permet de réaliser un décalage de tension par rapport à la ligne de polarisation associée et de déterminer la valeur d'impédance de sortie qui fixe le gain de l'amplificateur. L'association de la charge électrique passive 12 et du circuit d'amplification permet de convertir le signal en courant appliqué sur la borne d'entrée du circuit d'amplification en signal en tension sur la borne de sortie 7.

Dans un mode de réalisation préférentiel, la deuxième charge électrique passive 12 est configurée pour présenter une haute impédance et une faible capacité électrique. La deuxième charge électrique passive 12 est alors utilisée pour fixer un gain en tension du transistor d'amplification T3 pour le signal impulsionnel.

Dans un mode de réalisation particulier, la deuxième charge électrique passive 12 assure la fonction d'une source de courant qui est avantageusement saturée en l'absence d'impulsion lumineuse. La consigne en courant de cette source de courant, c'est-à-dire l'intensité du courant délivré en absence d'impulsion correspond sensiblement à la valeur représentative du signal à détecter et délivré par le photodétecteur 1. La source de courant est connectée à la deuxième électrode du transistor T3.

La deuxième charge électrique passive 12 est connectée à la borne de sortie 7.

L'intensité du courant traversant le transistor d'amplification T3 au repos, c'est-à-dire en l'absence d'impulsion est fixée par le potentiel appliqué sur l'électrode de commande du transistor d'amplification (ici l'électrode de grille ou la base) et par la valeur d'impédance de la première charge électrique passive 11.

La polarisation appliquée sur l'électrode de commande du transistor T3 provient d'une source de tension 14.

Les modes de réalisation illustrés aux figures 6 et 7 sont particulièrement avantageux car ils sont très compacts.

Les bornes du photodétecteur 1 sont connectées au circuit de polarisation afin d'imposer la première différence de potentiel. Le circuit d'amplification 8 est formé par le transistor d'amplification T3. Afin de gagner encore en compacité, le transistor d'amplification T3 est un transistor à effet de champ. Selon les modes de réalisation, l'électrode de source est connectée directement ou au moyen du condensateur de couplage 10 à la deuxième borne du photodétecteur 2.

La première charge électrique passive 11 est connectée à l'électrode de source et la deuxième charge électrique passive 12 est connectée à l'électrode de drain. La borne de sortie 7 du dispositif de détection est formée par la connexion commune entre l'électrode de drain du transistor d'amplification T3 et la deuxième charge électrique passive 12.

De manière avantageuse, le transistor d'amplification T3 est de type NMOS et il est couplé à la cathode du photodétecteur 1. Dans une variante de réalisation, le transistor d'amplification T3 est de type PMOS et il est couplé à l'anode du photodétecteur 1.

Dans un mode de réalisation préférentiel illustré aux figures 6 et 7, la première charge électrique passive 11 comporte ou est formée par un transistor additionnel monté en diode, par exemple un transistor PMOS monté en diode. Le transistor monté en diode est connecté à la borne commune entre l'électrode de source du transistor d'amplification T3 et le photodétecteur 1 ou le condensateur de couplage 10. En plus des avantages décrits plus haut, cette architecture est particulièrement compacte et facile à réaliser. Le transistor monté en diode est connecté entre une ligne de polarisation et la première électrode du circuit d'amplification 8.

Dans un autre mode de réalisation préférentiel pouvant être combiné avec les précédents, la deuxième charge électrique passive 12 comporte ou est formée par un autre transistor additionnel configuré pour former une source de courant, par exemple un transistor PMOS assurant la fonction de source de courant. Le transistor est connecté à l'électrode de drain du transistor d'amplification T3 afin de définir la borne de sortie 7 du dispositif de détection. Le transistor est également connecté à une ligne de polarisation qui délivre une première tension, par exemple la tension Vdd. Dans le mode de réalisation illustré à la figure 6, le transistor additionnel de la charge 12 est configuré pour former une diode. Dans le mode de réalisation de la figure 7, le transistor additionnel de la charge 12 a une électrode de commande reliée à une source de tension ce qui fixe le courant maximum délivré par le transistor additionnel. Dans cette configuration, la charge 12 forme une source de courant saturée. Le courant nominal de la charge 12 est représentatif du seuil de courant que l'on va détecter pour une impulsion.

Cette architecture permet de délivrer un signal binaire sur la borne de sortie 7. Ce signal est fonction de l'impulsion lumineuse détectée par le photodétecteur 1.

La deuxième charge électrique passive 12 peut comporter en plus un circuit de décalage des niveaux de tension, par exemple au moyen d'une diode afin de définir l'amplitude du signal de sortie. La diode peut être formée par un transistor. La diode est montée entre la source de courant 12 et la borne de sortie 7.

Le circuit de polarisation 6 du photodétecteur 1 comporte avantageusement un transistor additionnel monté en diode et connecté à la deuxième borne du photodétecteur 1 ce qui permet l'obtention d'une impédance suffisante sur un large domaine de polarisation. De manière avantageuse, le transistor est de type PMOS opposé à celui du transistor d'amplification (NMOS sur la figure 6) et il est connecté à la première tension Vdd. Cette configuration particulière est favorable à un meilleur transfert de l'impulsion de courant vers le transistor d'amplification dont les porteurs ont une meilleure mobilité. Le transistor additionnel monté en diode est connecté entre une ligne de polarisation et la première borne du photodétecteur 1.

La borne de sortie 7 du dispositif de détection est destinée à être connectée à un circuit d'analyse (non représenté) qui mémorise le passage des différentes impulsions. Dans une variante de réalisation, le circuit d'analyse est intégré dans le dispositif de détection. A titre d'exemple, la borne d'entrée du circuit d'analyse est la borne d'entrée d'une bascule, par exemple une bascule RS à entrée analogique.

En comparaison des documents de l'art antérieur cités plus haut, le dispositif de détection permet une amélioration de sensibilité importante (environ un facteur 10) tout en autorisant une consommation très faible.

Le dispositif de détection est particulièrement intéressant lorsqu'il comporte une matrice de photodétecteurs. Chaque photodétecteur est alors associé à un circuit de polarisation 6 et à un circuit d'amplification 8.

On entend par charges électrique 11 et 12, des charges de sortie qui recueillent le signal électrique fourni par la borne de sortie 7. Ces charges de sortie permettent d'utiliser la borne de sortie 7 pour faire sortir un signal en tension. Les charges 11 et 12 présentent des valeurs d'impédances choisies pour fournir un signal en tension. Les charges 11 et 12 peuvent indépendamment être des charges linéaires ou non linéaires. On entend par charge linéaire une charge dont la valeur de l'impédance est constante quelque soit la valeur du courant reçu. On entend par charge non linéaire une charge dont la valeur d'impédance varie en fonction du courant de polarisation. De manière particulièrement avantageuse, la valeur de l'impédance de la charge 11 augmente lorsque le courant de polarisation augmente.

## Revendications

1. Circuit de détection de rayonnement électromagnétique comportant :
- un photodétecteur (1) transformant le rayonnement électromagnétique reçu en un courant électrique,
- un circuit de polarisation (6) connecté aux bornes du photodétecteur (1),
- un circuit d'amplification (8) distinct du circuit de polarisation (6) et comportant un transistor d'amplification (T3) formé par un transistor à effet de champ ou un transistor bipolaire ayant une première électrode de source ou d'émetteur formant une borne d'entrée du circuit d'amplification (8) couplée à une borne du photodétecteur (1) et une deuxième électrode de drain ou de collecteur couplée à une borne de sortie (7) du circuit de détection, le circuit d'amplification (8) étant configuré de manière à ce que le transistor d'amplification soit parcouru par le courant appliqué sur la première électrode de source ou d'émetteur et à fournir ce courant sur la borne de sortie avec une impédance plus élevée que sur la première électrode de source ou d'émetteur,
- une source de tension (14) connectée à l'électrode de commande du transistor d'amplification (T3),
- une charge électrique passive (12) connectée à la deuxième électrode de drain ou de collecteur du transistor d'amplification (T3).

2. Circuit selon la revendication 1, **caractérisé en ce qu'**un condensateur de couplage (10) est connecté entre le photodétecteur (1) et la première électrode du transistor d'amplification (T3).

3. Circuit selon l'une des revendications 1 et 2, **caractérisé en ce que** la charge électrique passive (12) est une diode.

4. Circuit selon l'une quelconque des revendications 1 à 3, **caractérisé en ce qu'**il comporte une source de courant (12) saturée au repos connectée à la deuxième électrode du transistor de d'amplification (T3).

5. Circuit selon l'une quelconque des revendications 1 à 4, **caractérisé en ce qu'**une diode est montée entre une source de courant (12) et la borne de sortie (7).

6. Circuit selon l'une quelconque des revendications 1 à 5, **caractérisé en ce que** le circuit de polarisation (6) comporte un transistor additionnel monté en diode et connecté entre une ligne de polarisation et la première borne du photodétecteur (1).

7. Circuit selon l'une quelconque des revendications 1 à 6, **caractérisé en ce qu'**une charge passive (11) comporte un transistor additionnel monté en diode et connecté entre une ligne de polarisation et la première électrode du circuit d'amplification (8).

## Patentansprüche

1. Schaltkreis zur Erkennung von elektromagnetischer Strahlung, welcher umfasst:
- einen Fotodetektor (1), der die empfangene elektromagnetische Strahlung in einen elektrischen Strom umwandeln,
- einen Polarisationsschaltkreis (6), der mit den Anschlußklemmen des Fotodetektors (1) verbunden ist,
- einen Verstärkungsschaltkreis (8), der getrennt von dem Polarisationsschaltkreis (6) besteht und einen Verstärkungstransistor (T3) enthalt, der von einem Feldeffekttransistor oder einem bipolaren Transistor gebildet wird, der eine erste Quell- oder Emitterelektrode aufweist, die eine Eingangsklemme des Verstärkungsschaltkreises (8) bildet, welche mit einer Klemme des Fotodetektors (1) gekoppelt ist, sowie eine zweite Drain- oder Kollektorelektrode aufweist, die mit einer Ausgangsklemme (7) des Erkennungs-Schaltkreises gekoppelt ist, wobei der Verstärkungsschaltkreis (8) dergestalt konfiguriert ist, dass der Verstärkungstransistor von dem Strom durchflossen wird, der an der ersten Quell- oder Emitterelektrode angelegt wird, und dieser Strom an der Ausgangsklemme mit einem höheren Scheinwiderstand als an der ersten Quell- oder Emitterelektrode abgegeben wird,
- eine Spannungsquelle (14), die an die Steuerelektrode des Verstärkungstransistors (T3) angeschlossen ist,
- eine passive elektrische Ladung (12), die an die zweite Drain- oder Kollektorelektrode des Verstärkungstransistors (T3) angeschlossen ist.

2. Schaltkreis nach Anspruch 1,
**dadurch gekennzeichnet,**
**dass** ein Kopplungskondensator 10) zwischen dem Fotodetektor (1) und der ersten Elektrode des Verstärkungstransistors (T3) geschaltet ist.

3. Schaltkreis nach einem der Ansprüche 1 und 2,
**dadurch gekennzeichnet,**
**dass** die passive elektrische Ladung (12) eine Diode ist.

4. Schaltkreis nach einem der Ansprüche 1 bis 3,
**dadurch gekennzeichnet,**
**dass** er eine in Ruhestellung gesättigte Stromquelle (12) enthält, die mit der zweiten Elektrode des Verstärkungstransistors (T3) verbunden ist.

5. Schaltkreis nach einem der Ansprüche 1 bis 4,
**dadurch gekennzeichnet,**
**dass** eine Diode zwischen einer Stromquelle (12) und der Ausgangsklemme (7) geschaltet ist.

6. Schaltkreis nach einem der Ansprüche 1 bis 5,
**dadurch gekennzeichnet,**
**dass** der Polarisationsschaltkreis (6) einen zusätzlichen Transistor enthält, der als Diode aufgebaut und zwischen einer Polarisationsleitung und der ersten Klemme des Fotodetektors (1) geschaltet ist.

7. Schaltkreis nach einem der Ansprüche 1 bis 6,
**dadurch gekennzeichnet,**
**dass** eine passive Ladung (11) einen zusätzlichen Transistor enthält, der als Diode aufgebaut und zwischen einer Polarisationsleitung und der ersten Elektrode des Verstärkungsschaltkreises (8) geschaltet ist.

## Claims

1. Electromagnetic radiation detection circuit comprising:
- a photodetector (1) transforming the received electromagnetic radiation into an electric current,
- a bias circuit (6) connected to the terminals of the photodetector (1),
an amplifying circuit (8) different from the bias circuit (6) and comprising an amplifying transistor (T3) formed by a field-effect transistor or a bipolar transistor having a first source or emitter electrode forming an input terminal of the amplifying circuit (8) coupled to a terminal of the photo-detector (1) and a second drain or collector electrode coupled to an output terminal (7) of the detection circuit, the amplifying circuit (8) being configured so that the current applied to the first source or emitter electrode flows through the amplifying transistor and so as to provide this current on the output terminal with an impedance higher than on the first source or emitter electrode,
- a voltage source (14) connected to the control electrode of the amplifying transistor (T3),
- a passive electric load (12) connected to the second drain or collector electrode of the amplifying transistor (T3).

2. Circuit according to claim 1, **characterized in that** a coupling capacitor (10) is connected between the photodetector (1) and the first electrode of the amplifying transistor (T3).

3. Circuit according to any of claims 1 and 2, **characterized in that** the passive electric load (12) is a diode.

4. Circuit according to any of claims 1 to 3, **characterized in that** it comprises a current source (12) saturated in the idle state connected to the second electrode of the amplifying transistor (T3).

5. Circuit according to any of claims 1 to 4, **characterized in that** a diode is assembled between a current source (12) and the output terminal (7).

6. Circuit according to any of claims 1 to 5, **characterized in that** the bias circuit (6) comprises an additional diode-connected transistor connected between a bias line and the first terminal of the photodetector (1).

7. Circuit according to any of claims 1 to 6, **characterized in that** a passive load (11) comprises an additional diode-connected transistor connected between a bias line and the first electrode of the amplifying circuit (8).
